Europäisches Patentamt

European Patent Office

Office européen des brevets

(19)

(11) **EP 1 149 478 B1**

(12) **EUROPÄISCHE PATENTSCHRIFT**

(45) Veröffentlichungstag und Bekanntmachung des Hinweises auf die Patenterteilung:
**04.06.2003 Patentblatt 2003/23**

(21) Anmeldenummer: 00908986.3

(22) Anmeldetag: **04.02.2000**

(51) Int Cl.⁷: $H04B\ 3/23$, $H04B\ 1/58$

(86) Internationale Anmeldenummer:
**PCT/DE00/00349**

(87) Internationale Veröffentlichungsnummer:
**WO 00/046936 (10.08.2000 Gazette 2000/32)**

(54) **ANALOGES ECHOFILTER**

ANALOGUE ECHO FILTER

ECHOFILTRE ANALOGIQUE

(84) Benannte Vertragsstaaten:
**AT BE CH CY DE DK ES FI FR GB GR IE IT LI LU MC NL PT SE**

(30) Priorität: **05.02.1999 DE 19904856**

(43) Veröffentlichungstag der Anmeldung:
**31.10.2001 Patentblatt 2001/44**

(73) Patentinhaber: **Infineon Technologies AG
81669 München (DE)**

(72) Erfinder:
• **PECOURT, Frederic
A-9500 Villach (AT)**

• **HAUPTMANN, Jörg
A-9241 Wernberg (AT)**
• **TENEN, Aner
49133 Petach Tikva (IL)**

(74) Vertreter: **Barth, Stephan Manuel, Dr. et al
Reinhard-Skuhra-Weise & Partner Gbr,
Patentanwälte
Friedrichstrasse 31
80801 München (DE)**

(56) Entgegenhaltungen:
**EP-A- 0 798 876          US-A- 4 608 464
US-A- 4 796 296**

**Beschreibung**

Die vorliegende Erfindung betrifft ein analoges Echofilter gemäß dem Oberbegriff des Anspruchs 1, wie aus der US-A-4,608,464 bekannt.

Die US-A-4,796,296 offenbart einen PCM-Kodierer und -Dekodierer mit der Funktion einer Zweidraht-/Vierdraht-Umwandlung. In dieser Druckschrift wird auch die Verwendung eines passiven- Vorfilters beschrieben.

Bei der Übertragung von Signalen über Zweidrahtleitung werden in einem Modem, das Signale vollduplex überträgt, zur Unterdrückung von Echos im Empfangssignal analoge Echofilter eingesetzt. Ein Echo entsteht durch eine Überlagerung der Frequenzbereiche des Sende- und Empfangssignals. Ein analoges Echofilter bildet die Leitungsimpedanz der Zweidrahtleitung nach und ist zwischen dem Sende- und Empfangspfad geschaltet. Ein zu sendendes Signal, daß aufgrund des Leitungsechos einem zu empfangenen Signal störend überlagert ist, wird dem analogen Echofilter zugeführt und entsprechend der Leitungsimpedanz der Zweidrahtleitung gefiltert. Das Ausgangssignal des analogen Echofilters ähnelt dann mehr oder weniger dem im zu empfangenen Signal enthaltenen Echo und wird zur Echounterdrückung von dem zu empfangenden Signal subtrahiert. Zur wirksamen Echounterdrückung muß also das Echofilter so gut wie möglich die Leitungsimpedanz der Übertragungsleitung nachbilden (wird im Englischen auch mit "Balancing" bezeichnet; Echofilter werden deshalb auch als "Balancing-Filter" bezeichnet). Insbesondere für High-Speed-Daten-Modems, die mit einem xDSL-Übertragungsverfahren (z.B. ADSL, HDSL) arbeiten, ist zu Erreichung einer hohen Datenübertragungsrate die Echounterdrückung von besonderer Bedeutung.

Um diesen hohen Anforderungen zu genügen, wird als analoges Echofilter beispielsweise ein vollständig aus passiven Bauelementen aufgebautes Echofilter, dessen Impedanz möglichst der Leitungsimpedanz der Zweidrahtleitung entsprechen sollte, verwendet. Teilweise werden auch analoge Echofilter zur Grobanpassung der Echodämpfung und digitale Filter in Kombination mit Analog-Digital-Umsetzern und Digital-Analog-Umsetzern zur Feineinstellung verwendet. Ein solches Echofilter ist beispielsweise aus WO 93/04539 bekannt. Dort ist ein Echofilter beschrieben, das sich an verschiedene Leitungsimpedanzen digital anpassen läßt. Allerdings ist die Lösung sehr aufwendig und die Anpaßbarkeit des Echofilters ist durch die Auflösung der Analog-Digital-Umsetzer begrenzt.

Das der Erfindung zugrunde liegende technische Problem liegt daher darin, ein analoges Echofilter anzugeben, das an verschiedene Leitungsimpedanzen anpaßbar ist und dabei kostengünstig herstellbar ist.

Dieses Problem wird mit einem analogen Echofilter für ein Modem mit den Merkmalen von Patentanspruch 1 gelöst. Vorteilhafte Ausgestaltungen ergeben sich aus den jeweiligen Unteransprüchen.

Die Erfindung betrifft ein analoges Echofilter für ein Modem, dem ein analoges Sendesignal zugeführt wird. Erfindungsgemäß sind ein passives analoges Vorfilter und ein aktives analoges Filter, dessen Übertragungsfunktion einstellbar ist, vorgesehen. Bevorzugt ist die Übertragungsfunktion des aktiven analogen Filters zwischen einer Übertragungsfunktion erster Ordnung und einer Übertragungsfunktion zweiter Ordnung umschaltbar. Vorteilhafterweise kann dadurch die Übertragungsfunktion und damit die Echodämpfung an verschieden Übertragungsleitungen angepaßt werden. In einer besonders bevorzugten Ausführungsform besteht das passive analoge Vorfilter aus Widerständen und Kondensatoren. Das aktive analoge Filter weist bevorzugt Operationsverstärker, Widerstände, Kondensatoren und Schalter auf. Von Vorteil ist dabei die einfache Ausführbarkeit mit analogen Komponenten. Ein weiterer Vorteil ergibt sich durch die präzise Einstellbarkeit des analogen Echofilters. Das aktive analoge Filter weist besonders bevorzugt drei Operationsverstärker, die in Reihe geschaltet sind, auf, wobei der erste Operationsverstärker und der zweite Operationsverstärker der Reihenschaltung Kondensatoren, die jeweils die Ausgänge auf die Eingänge eines Operationsverstärkers zurückkoppeln, aufweist. Der zweite Operationsverstärker der Reihenschaltung ist bevorzugt durch Schalter zur Einstellung einer Übertragungsfunktion erster Ordnung des aktiven analogen Filters überbrückbar. Diese Ausführungsform läßt sich vorteilhafterweise einfach als integrierte Schaltung ausführen, wodurch sich gegenüber einer Ausführung mit diskreten Bauelementen deutliche Kostenvorteile ergeben.

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigt

Figur 1 ein Blockdiagramm des analogen Echofilters nach der Erfindung, und

Figur 2 ein Ausführungsbeispiel des analogen Echofilters nach der Erfindung.

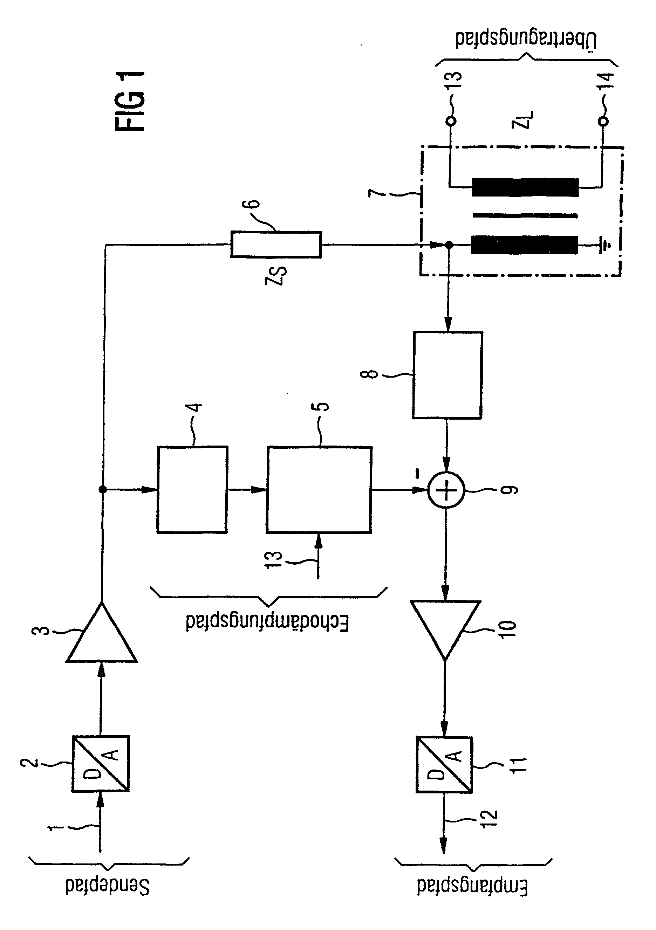

In Figur 1 ist ein Blockschaltbild mit den für die Erfindung wesentlichen Komponenten dargestellt. Das dargestellte Blockschaltbild entspricht dabei dem Sende- und Empfangsteil eines ADSL-Modems.

Das Sende- und Empfangsteil eines Modems weist einen Sendepfad, einen Empfangspfad, einen Echodämpfungspfad zur Unterdrückung des im Empfangssignal enthaltenen Echos und eine Hybridschaltung zur Trennung bzw. Kombination von Sende- und Empfangssignal auf.

Im Sendepfad wird ein digitales Sendesignal 1 einem Digital-Analog-Umsetzer 2 zugeführt, der das digitale Sendesignal in ein analoges Sendesignal umsetzt.

Das analoge Sendesignal wird einem Verstärker 3 zugeführt, der das Signal auf einen zur Übertragung erforderlichen Pegel verstärkt.

Das verstärkte analoge Sendesignal wird einerseits einem analogen Vorfilter 4, der in den Echodämpfungspfad geschaltet ist, und andererseits einer Impedanz 6 (ZS) zugeführt.

Das analoge Vorfilter dient zum Vorbalancieren des Echodämpfungspfades und zum Einstellen einer Abschlußimpedanz für die analoge Hybridschaltung.

Das Ausgangssignal des analogen Vorfilters 4 wird einem aktiven analogen anpaßbaren Echofilter 5 zugeführt. Das anpaßbare aktive analoge Echofilter 5 ist über Steuerleitungen 13 auf unterschiedliche Leitungsimpedanzen einstellbar.

Das Ausgangssignal des analogen aktiven einstellbaren Echofilters 5 wird einer Subtrahiererschaltung 9 zugeführt und von einem analogen Empfangssignal, das im Empfangspfad verarbeitet wird, subtrahiert.

Das analoge Empfangssignal wird von einer analogen Hybridschaltung 7 aus einem Signal auf einer Zweidrahtleitung gefiltert.

Dazu ist die analoge Hybridschaltung 7, die in vereinfachter Darstellung aus einem Transformator besteht, leitungsseitig über zwei Anschlüsse 13 und 14 mit einer zweiadrigen Übertragungsleitung verbindbar. Die zweiadrige Übertragungsleitung bildet mit einer Gegenstelle zwischen den zwei Anschlüssen 13 und 14 eine Leitungsimpedanz ZL, die durch den Übertrager auf den Sendepfad, den Echodämpfungspfad und den Empfangspfad transformiert wird. Das analoge Empfangssignal wird durch eine analoges Vorfilter 8 gefiltert und der Subtrahiererschaltung 9 zugeführt. Am Ausgang der Subtrahiererschaltung 9 liegt ein echogefiltertes Empfangssignal an, das einer Verstärkerschaltung mit automatischer Verstärkungskontrolle 10 zugeführt wird.

Die Verstärkerschaltung mit automatischer Verstärkungskontrolle 10 verstärkt das echogefilterte Empfangssignal auf einen Pegel, der die Auflösung eines nachgeschalteten Analog-Digital-Umsetzers 11 voll ausnutzt.

Der Analog-Digital-Umsetzer 11 setzt das echogefilterte analoge Empfangssignal in ein digitales Empfangssignal 12 um.

Um eine möglichst effiziente Echounterdrückung des analogen Empfangssignals zu erreichen, ist die Übertragungsfunktion des aktiven analogen Echofilters 5 einstellbar. Für eine wirksame Echodämpfung 5 hat sich eine Übertragungsfunktion erster oder zweiter Ordnung als brauchbar erwiesen. Der Vorteil einer Übertragungsfunktion erster oder zweiter Ordnung besteht zudem in der verhältnismäßig einfachen Ausführbarkeit mit Operationsverstärkern, Widerständen und Kondensatoren.

Die Übertragungsfunktion erster Ordnung lautet:

$$H_1(p) = \frac{a_1 \cdot p + a_0}{b_1 \cdot p + b_0}$$

Die Übertragungsfunktion zweiter Ordnung lautet:

$$H_2(p) = \frac{a_2 \cdot p^2 + a_1 \cdot p + a_0}{b_2 \cdot p^2 + b_1 \cdot p + b_0}$$

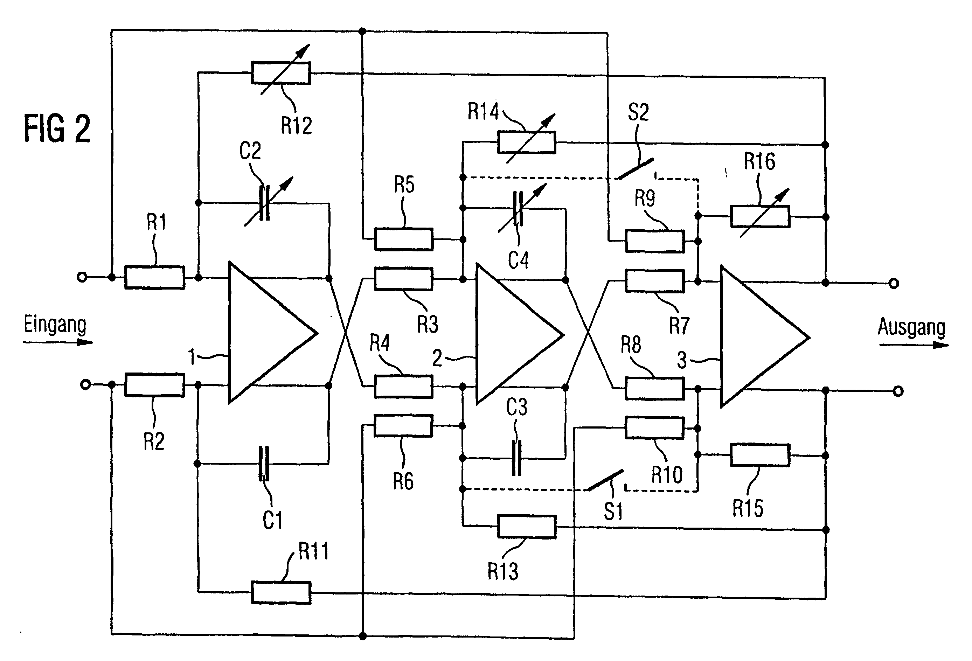

Figur 2 zeigt ein Ausführungsbeispiel für das aktive analoge einstellbare Echofilter.

Die abgebildete Schaltung weist drei differentielle Operationsverstärker 1, 2 und 3 auf. Jedem der differentiellen Operationsverstärker sind jeweils Eingangswiderstände R1, R2 bzw. R3, R4 bzw. R7, R8 vorgeschaltet. Die Operationsverstärker 1 und 2 sind jeweils über Kapazitäten C1, C2 bzw. C3, C4 rückgekoppelt. Die Rückkoppelkapazität C2 des Operationsverstärkers 1 und die Rückkoppelkapazität C4 des Operationsverstärkers 2 ist zur Anpassung der Übertragungsfunktion des Echofilters einstellbar. Der dritte Operationsverstärker 3 ist über Widerstände R15, R16 rückgekoppelt. Der Widerstand R16 ist dabei einstellbar.

Ein Eingangssignal des analogen aktiven Echofilters wird dem ersten Operationsverstärker 1, dem zweiten Operationsverstärker 2 über Widerstände R5 und R6 und dem dritten Operationsverstärker 3 über Widerstände R9 und R10 zugeführt.

Über Schalter S1 und S2 sind die Eingänge des zweiten Operationsverstärkers S2 mit den Eingängen des dritten Operationsverstärkers 3 verbindbar. Dadurch kann der zweite Operationsverstärker überbrückt werden und von einer Übertragungsfunktion zweiter Ordnung $H_2(p)$ auf eine Übertragungsfunktion erster Ordnung $H_1(p)$ des Echofilters umgeschaltet werden.

Weiterhin sind die Eingänge des ersten Operationsverstärkers über Widerstände R11 und R12 und die Eingänge des zweiten Operationsverstärkers über Widerstände R13 und R14 mit den Ausgängen des analogen Echofilters verbunden. Die Widerstände R12 und R14 sind dabei zur Anpassung der Übertragungsfunktion des analogen Echofilters einstellbar.

Vorteilhafterweise ist dieses Ausführungsbeispiel mit verhältnismäßig geringem Aufwand als integrierte Schaltung ausführbar. Die Steuerung der Widerstände R12, R14, R16, der Kapazitäten C2, C4 und der Schalter S1, S2 kann dabei durch integrierte digitale Schaltungen vorgenommen werden. Dadurch ist das analoge Echofilter sehr einfach steuerbar.

**Patentansprüche**

1. Analoges Echofilter für einen Echodämpfungspfad eines Modems, der zwischen einem Sendepfad und einem Empfangspfad liegt, wobei dem Modem ein analoges Sendesignal, das über eine Übertragungsleitung vollduplex übertragen wird, über den Sendepfad zuführbar ist, wobei das Modem eine analoge Hybridschaltung zur Trennung bzw. Kombination von dem Sende- und einem Enpfangssignal aufweist, das über den Empfangspfad ausgebbar ist, mit einem aktiven analogen Filter (5), dessen übertragungsfunktion einstellbar ist,
**dadurch gekennzeichnet,**
**daß**
ein passiver analoger Vorfilter (4) zum Vorbalancieren des Echodampfungspfades und zum Einstellen einer Abschlußimpedanz für die analoge Hybridschaltung vorgesehen ist;
die Übercragungsfunktion des aktiven analogen Filters (5) zwischen einer Übertragungsfunktion erster Ordnung und einer Übertragungsfunktion zweiter Ordnung umschaltbar ist;
das aktive analoge Filter (5) drei Operationsverstärker (1, 2, 3), die in Reihe geschaltet sind, aufweist; und
der zweite Operationsverstärker (2) der Reihenschaltung durch Schalter (S1, S2) zur Umstellung von einer Übertragungsfunktion zweiter Ordnung auf eine eine Übertragungsfunktion erster Ordnung des aktiven analogen Filters (5) überbrückbar ist.

**2.** Analoges Echofilter nach Anspruch 1,
**dadurch gekennzeichnet,**
**daß** das passive analoge Vorfilter (4) aus Widerständen und Kondensatoren besteht.

**3.** Analoges echofilter nach Anspruch 1 oder 2,
**dadurch gekennzeichnet,**
**daß** der erste Operationsverstärker (1) und der zweite Operationsverstärker (2) der Reihenschaltung Kondensatoren (C1, C2 bzw. C3, C4), die jeweils die Ausgänge auf die Eingänge eines Operationsverstärkers zurückkoppeln, aufweist.

## Claims

**1.** Analogue echo filter for an echo damping path of a modem, which is located between a transmit path and a receive path, in which case the modem can be supplied with an analogue transmit signal, which is transmitted in full-duplex via a transmission line, via the transmit path, with the modem having an analogue hybrid circuit for separating and combining the transmit signal and a received signal which can be output via the receive path, and having an active analogue filter (5), whose transfer function is adjustable,
**characterized in that**
a passive analogue input filter (4) is provided for input balancing of the echo damping path and for adjusting a terminating impedance for the analogue hybrid circuit;
the transfer function of the active analogue filter (5) can be switched between a first-order transfer function and a second-order transfer function;
the active analogue filter (5) has three operational amplifiers (1, 2, 3), which are connected in series; and
the second operational amplifier (2) in the series circuit can be bridged by switches (S1, S2) in order to switch the active analogue filter (5) from a second-order transfer function to a first-order transfer function.

**2.** Analogue echo filter according to Claim 1
**characterized in that**
the passive analogue input filter (4) comprises resistors and capacitors.

**3.** Analogue echo filter according to Claim 1 or 2,
**characterized in that**
the first operational amplifier (1) and the second operational amplifier (2) in the series circuit have capacitors (C1, C2 and C3, C4) which respectively feed back the outputs to the inputs of an operational amplifier.

## Revendications

**1.** Echofiltre analogique pour un bus d'amortissement d'écho d'un modem, qui est disposé entre un bus d'émission et un bus de réception, dans lequel on peut acheminer au modem via le bus d'émission un signal d'émission analogique, qui est transmis en mode full duplex via une ligne de transmission, le modem présentant un circuit hydride analogique pour séparer ou combiner le signal d'émission et le signal de réception; qui peut être extrait via le bus de réception, avec un filtre analogique actif (5), dont la fonction de transmission peut être réglée,
**caractérisé en ce que** :

il est prévu un préfiltre analogique passif (4) pour pré-équilibrer le bus d'amortissement d'écho et pour régler une impédance terminale pour le circuit analogique hybride;
la fonction de transmission du filtre analogique actif (5) peut être commutée entre une fonction de transmission du premier ordre et une fonction de transmission du deuxième ordre;
le filtre analogique actif (5) présente trois amplificateurs opérationnels (1, 2, 3), qui sont connectés en série; et
le deuxième amplificateur opérationnel (2) du circuit en série peut être ponté par des commutateurs (S1, S2) pour passer d'une fonction de transmission du deuxième ordre à une fonction de transmission du premier ordre du filtre analogique actif (5).

2. Echofiltre analogique selon la revendication 1, **caractérisé en ce que** le préfiltre analogique passif (4) est constitué de résistances et de condensateurs.

3. Echofiltre analogique selon la revendication 1 ou 2, **caractérisé en ce que** le premier amplificateur opérationnel (1) et le deuxième amplificateur opérationnel (2) du circuit en série présentent des condensateurs (C1, C2 ou C3, C4), qui réinjectent respectivement les sorties sur les entrées d'un amplificateur opérationnel.

FIG 1

FIG 2